# EUROPEAN PATENT APPLICATION

(11) **EP 4 249 631 A1**
(43) Date of publication of application: **27.09.2023**
(21) Application number: 21894642.4
(22) Date of filing: 16.11.2021
(51) Int. Cl.: C23C 16/40, H01L 21/31, H01L 21/316

(54) **METHOD FOR MANUFACTURING THIN FILM**

(30) Priority: 19.11.2020 JP 2020192293
(71) Applicant: ADEKA CORPORATION, Arakawa-ku Tokyo 116-8554 (JP)
(72) Inventor: NISHIDA, Akihiro, Tokyo 116-8554 (JP); HATASE, Masako, Tokyo 116-8554 (JP); YOSHINO, Tomoharu, Tokyo 116-8554 (JP); OOE, Yoshiki, Tokyo 116-8554 (JP); MITSUI, Chiaki, Tokyo 116-8554 (JP)
(74) Representative: Müller-Boré & Partner Patentanwälte PartG mbB
(86) International application number: PCT/JP2021/042093
(87) International publication number: WO 2022/107768

(57) **Abstract**

Provided is a method of producing a thin-film containing a zirconium atom on a surface of a substrate by an atomic layer deposition method, including: a step 1 of causing a raw material gas obtained by vaporizing a thin-film forming raw material containing a zirconium compound represented by the following general formula (1) to adsorb to the surface of the substrate to form a precursor thin-film; a step 2 of evacuating the raw material gas remaining unreacted; and a step 3 of causing the precursor thin-film to react with a reactive gas at a temperature of 240°C or more and 450°C or less to form the thin-film containing a zirconium atom on the surface of the substrate: 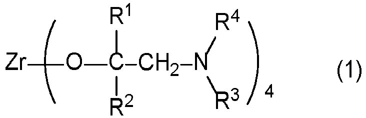 wherein R¹ and R² each independently represent a hydrogen atom or an alkyl group having 1 to 3 carbon atoms, and R³ and R⁴ each independently represent an alkyl group having 1 to 3 carbon atoms, provided that a zirconium compound in which both of R¹ and R² represent hydrogen atoms is excluded.

## Description

### Technical Field

The present invention relates to a method of producing a thin-film by an atomic layer deposition method (ALD method) through use of a zirconium compound having a specific amino alkoxide as a ligand.

### Background Art

In a semiconductor production process, a high dielectric material (High-k) has been required in order to meet performance demands for a high capacitance, a low leakage current, and low power consumption. Zirconium oxide (ZrO₂) is known as a high dielectric material, and has excellent properties, such as a wide bandgap, a high refractive index, and satisfactory thermal stability. Accordingly, ZrO₂ is used for forming, for example, a capacitor dielectric in a dynamic random access memory (DRAM) element, a gate insulating layer in a metal oxide semiconductor field effect transistor (MOSFET), or a tunnel gate dielectric in a flash memory circuit.

A thin-film of ZrO₂ is used in the above-mentioned semiconductor applications. As a method of producing the thin-film of ZrO₂, there are given, for example: a sputtering method; an ion plating method; a MOD method, such as a coating thermal decomposition method or a sol-gel method; and a CVD method. Of those, an atomic layer deposition method (sometimes referred to as "ALD method") is an optimum production process because the method has, for example, the following many advantages: the method has film thickness controllability at an atomic layer level; the method is excellent in composition controllability and step coverage; the method is suitable for mass production; and the method enables hybrid integration.

There have been reported various materials that may be used in vapor phase thin-film formation methods, such as the CVD method and the ALD method. However, a thin-film forming raw material applicable to the ALD method needs to have a temperature region called an ALD window, and the temperature region needs to be sufficiently wide. Accordingly, it is common general technical knowledge in the art that even a thin-film forming raw material that may be used in the CVD method is not suitable for the ALD method in many cases.

In Patent Document 1, there is a disclosure of a production method including forming a thin-film by a CVD method through use of zirconium tetra(dimethylaminoethoxide).

In Patent Document 2, there is a disclosure that a thin-film of zirconium oxide is formed at 250°C by an ALD method through use of tetrakisethylmethylaminozirconium (TEMAZ) as a raw material, and a mixture of an oxygen gas and an ozone gas as a reactive gas.

### Citation List

### Patent Document

Patent Document 1: JP 3499804 B2
Patent Document 2: JP 2020-53612 A

### Summary of Invention

### Technical Problem

The ALD method is a method of stacking atomic layers one by one on a substrate set in a vacuum container by repetitively performing: a step of causing a molecule of a raw material compound to adsorb to the surface of the substrate; a film forming step based on a reaction between the molecule having adsorbed to the surface of the substrate and a reactive gas; and a step of removing the redundant molecule through purging. Thus, the ALD method enables uniform film control at an atomic layer level, and hence enables the formation of a film having high homogeneity and high step coverage. However, the ALD method has difficulty in performing film formation at high temperature as compared to the CVD method, and has a problem in that carbon is liable to remain in the film.

In Patent Document 1, there is no description of a specific example in which zirconium tetra(dimethylaminoethoxide) is applied to the ALD method, and there are no descriptions of production conditions in the case of using the ALD method.

In the case described in Patent Document 2 in which the thin-film is formed at a temperature of more than 250°C by the ALD method through use of tetrakisethylmethylaminozirconium (TEMAZ), there has been a problem in that a large amount of carbon remains in the film.

Accordingly, an object of the present invention is to provide a method of producing a thin-film containing a zirconium atom (hereinafter referred to as "zirconium-containing thin-film"), which is a high-quality thin-film reduced in residual carbon, by an ALD method.

### Solution to Problem

The inventors of the present invention have made extensive investigations and found that the above-mentioned problems can be solved by producing a zirconium-containing thin-film by an ALD method under the specific conditions through use of a thin-film forming raw material containing a zirconium compound having a specific structure, to complete the present invention.

That is, according to one embodiment of the present invention, there is provided a method of producing a thin-film containing a zirconium atom on a surface of a substrate by an atomic layer deposition method, including: a step 1 of causing a raw material gas obtained by vaporizing a thin-film forming raw material containing a zirconium compound represented by the following general formula (1) to adsorb to the surface of the substrate to form a precursor thin-film; a step 2 of evacuating the raw material gas remaining unreacted; and a step 3 of causing the precursor thin-film to react with a reactive gas at a temperature of 240°C or more and 450°C or less to form the thin-film containing a zirconium atom on the surface of the substrate.

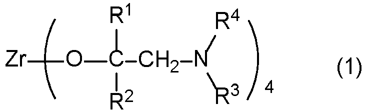

In the formula, R¹ and R² each independently represent a hydrogen atom or an alkyl group having 1 to 3 carbon atoms, and R³ and R⁴ each independently represent an alkyl group having 1 to 3 carbon atoms, provided that a zirconium compound in which both of R¹ and R² represent hydrogen atoms is excluded.

In the method of producing a thin-film according to the one embodiment of the present invention, it is preferred that the step 1 be performed under a state in which the substrate is heated to 240°C or more and 450°C or less.

In the method of producing a thin-film according to the one embodiment of the present invention, it is preferred that the reactive gas be an oxidizing gas, and the thin-film containing a zirconium atom be zirconium oxide.

In the method of producing a thin-film according to the one embodiment of the present invention, it is preferred that the reactive gas be a gas containing at least one selected from the group consisting of: oxygen; ozone; and water vapor.

### Advantageous Effects of Invention

According to the present invention, the zirconium-containing thin-film, which is a high-quality thin-film reduced in residual carbon, can be produced.

### Brief Description of Drawings

FIG. 1 is a schematic diagram for illustrating an example of an ALD apparatus to be used in a method of producing a thin-film of the present invention.
FIG. 2 is a schematic diagram for illustrating another example of the ALD apparatus to be used in the method of producing a thin-film of the present invention.
FIG. 3 is a schematic diagram for illustrating still another example of the ALD apparatus to be used in the method of producing a thin-film of the present invention.
FIG. 4 is a schematic diagram for illustrating yet still another example of the ALD apparatus to be used in the method of producing a thin-film of the present invention.

### Description of Embodiments

A method of producing a thin-film of the present invention is described. The method of producing a thin-film of the present invention is a method including: a step 1 of causing a raw material gas obtained by vaporizing a thin-film forming raw material containing a zirconium compound represented by the general formula (1) to adsorb to a surface of a substrate to form a precursor thin-film; a step 2 of evacuating the raw material gas remaining unreacted; and a step 3 of causing the precursor thin-film to react with a reactive gas at a temperature of 240°C or more and 450°C or less to form a zirconium-containing thin-film on the surface of the substrate.

In the general formula (1), R¹ and R² each independently represent a hydrogen atom or an alkyl group having 1 to 3 carbon atoms, and R³ and R⁴ each independently represent an alkyl group having 1 to 3 carbon atoms. Provided that both of R¹ and R² cannot be hydrogen atoms.

The zirconium compound represented by the general formula (1), which is used as a precursor for forming a thin-film by an ALD method, preferably has a melting point of 100°C or less, and from the viewpoint that easy handleability is achieved, the compound is more preferably a liquid at normal temperature. In addition, the thermal decomposition starting temperature of the zirconium compound obtained with a differential scanning calorimeter (DSC) is preferably 250°C or more, and from the viewpoint that excellent thermal stability is achieved, the temperature is more preferably 260°C or more.

Examples of the alkyl group having 1 to 3 carbon atoms represented by each of R¹, R², R³, and R⁴ in the general formula (1) include a methyl group, an ethyl group, a n-propyl group, and an isopropyl group. From the viewpoint that the effects of the present invention become remarkable, such a zirconium compound that, in the general formula (1), R¹ represents a hydrogen atom, a methyl group, or an ethyl group, R² represents a hydrogen atom, a methyl group, or an ethyl group, R³ represents a methyl group or an ethyl group, and R⁴ represents a methyl group or an ethyl group is preferred. In particular, from the viewpoint that excellent thermal stability is achieved, such a zirconium compound that, in the general formula (1), R¹, R³, and R⁴ each represent a methyl group, and R² represents a hydrogen atom or a methyl group is more preferred, and such a zirconium compound that, in the general formula (1), R¹, R³, and R⁴ each represent a methyl group, and R² represents a hydrogen atom is still more preferred.

Preferred specific examples of the zirconium compound represented by the general formula (1) include Compounds No. 1 to No. 15 below. However, the present invention is not limited to those zirconium compounds. In Compounds No. 1 to No. 15 below, "Me" represents a methyl group, and "Et" represents an ethyl group.

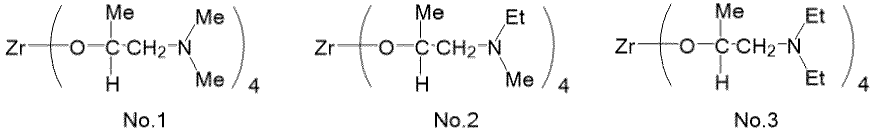

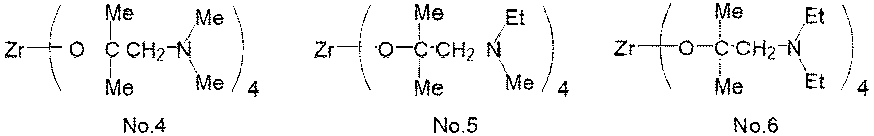

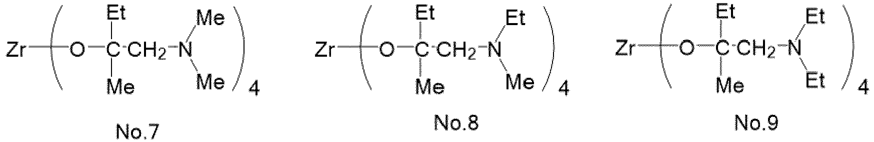

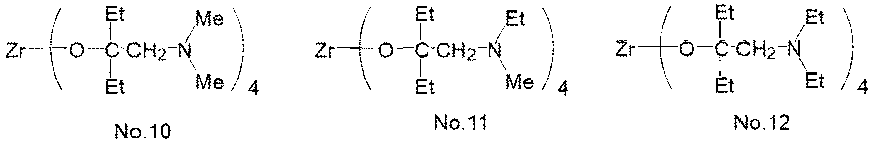

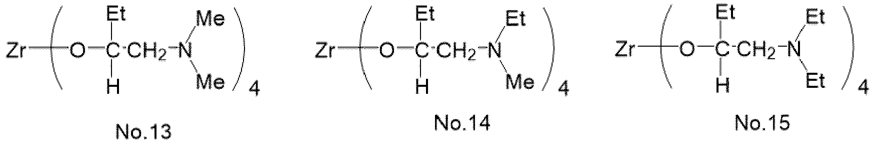

The zirconium compound represented by the general formula (1) may be produced by utilizing a well-known reaction. For example, such a zirconium compound that, in the general formula (1), R¹, R³, and R⁴ each represent a methyl group, and R² represents a hydrogen atom may be obtained by causing tetrakis(diethylamino)zirconium (TDEAZ) and 1-dimethylamino-2-propanol to react with each other.

The thin-film forming raw material to be used in the method of producing a thin-film of the present invention only needs to contain the zirconium compound represented by the general formula (1) as a precursor of a thin-film, and the composition thereof varies depending on the composition of a thin-film to be targeted. For example, when a thin-film containing only zirconium as a metal is produced, the thin-film forming raw material is free of a metal compound other than zirconium and a semimetal compound. Meanwhile, when a thin-film containing zirconium and another metal and/or semimetal is produced, the thin-film forming raw material may include a compound containing the desired metal and/or a compound containing the desired semimetal (hereinafter referred to as "other precursor") in addition to the zirconium compound represented by the general formula (1).

In the case of a multi-component ALD method in which a plurality of precursors are used, there is no particular limitation on the other precursor that may be used together with the zirconium compound represented by the general formula (1), and a well-known general precursor used for the thin-film forming raw material for an ALD method may be used.

Examples of the above-mentioned other precursor include compounds each formed of: one or two or more selected from the group consisting of compounds used as organic ligands, such as an alcohol compound, a glycol compound, a β-diketone compound, a cyclopentadiene compound, and an organic amine compound; and boron or a metal. In addition, examples of the kind of the metal in the precursor include lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, ruthenium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the above-mentioned other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the above-mentioned other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the above-mentioned other precursor include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the above-mentioned other precursor include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene.

Examples of the organic amine compound to be used as the organic ligand in the above-mentioned other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The above-mentioned other precursors are known in the art, and production methods therefor are also known. An example of the production methods is given as described below. For example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal. Examples of the alkali metal alkoxide may include a sodium alkoxide, a lithium alkoxide, and a potassium alkoxide.

Examples of such a multi-component ALD method as described above include: a method involving vaporizing and supplying each component of the thin-film forming raw material independently (hereinafter sometimes referred to as "single source method"); and a method involving vaporizing and supplying a mixed raw material obtained by mixing multi-component raw materials in accordance with desired composition in advance (hereinafter sometimes referred to as "cocktail source method"). In the case of the single source method, the above-mentioned other precursor is preferably a compound similar to the zirconium compound represented by the general formula (1) in the behavior of thermal decomposition and/or oxidative decomposition. In the case of the cocktail source method, the above-mentioned other precursor is preferably a compound that not only is similar to the zirconium compound represented by the general formula (1) in the behavior of thermal decomposition and/or oxidative decomposition but also is prevented from being altered through a chemical reaction or the like at the time of mixing.

In the case of the cocktail source method in the multi-component ALD method, a mixture of the zirconium compound represented by the general formula (1) and the other precursor, or a mixed solution obtained by dissolving the mixture in an organic solvent may be used as the thin-film forming raw material.

There is no particular limitation on the above-mentioned organic solvent, and a well-known general organic solvent may be used. Examples of the organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof depending on the solubility of a solute, the relationship among the use temperature, boiling point, and flash point of the solvent, and the like.

In the method of producing a thin-film of the present invention, when the thin-film forming raw material is a mixed solution including the organic solvent, the total precursor amount in the thin-film forming raw material may be controlled to from 0.01 mol/liter to 2.0 mol/liter, particularly from 0.05 mol/liter to 1.0 mol/liter.

Herein, when the thin-film forming raw material is free of the metal compound other than zirconium and the semimetal compound, the total precursor amount represents the amount of the zirconium compound represented by the general formula (1) (however, when the thin-film forming raw material contains a zirconium compound other than the zirconium compound represented by the general formula (1), the total precursor amount represents the total amount thereof). When the thin-film forming raw material contains the other precursor in addition to the zirconium compound represented by the general formula (1), the total precursor amount represents the total amount of the zirconium compound represented by the general formula (1) and the other precursor.

In addition, in the method of producing a thin-film of the present invention, the thin-film forming raw material may include a nucleophilic reagent for improving the stability of each of the zirconium compound represented by the general formula (1) and the other precursor as required. Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane. From the viewpoint that the control of the stability becomes easy, the usage amount of such nucleophilic reagent falls within the range of preferably from 0.1 mol to 10 mol, more preferably from 1 mol to 4 mol with respect to 1 mol of the total precursor amount.

It is desired that the thin-film forming raw material be prevented from including impurity metal elements other than the components for forming the raw material, impurity halogens such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, or a barrier layer of an LSI, it is required to reduce the contents of alkali metal elements and alkaline-earth metal elements that influence the electrical characteristics of a thin-film to be obtained. The content of the impurity halogens is preferably 100 ppm or less, more preferably 10 ppm or less, still more preferably 1 ppm or less. The total content of the impurity organic substances is preferably 500 ppm or less, more preferably 50 ppm or less, still more preferably 10 ppm or less. In addition, moisture causes generation of particles in a raw material for ALD and generation of particles during thin-film formation. Accordingly, in order to reduce moisture in each of the precursor, the organic solvent, and the nucleophilic reagent, the moisture is desirably removed as much as possible in advance at the time of use. The moisture content of each of the precursor, the organic solvent, and the nucleophilic reagent is preferably 10 ppm or less, more preferably 1 ppm or less.

In addition, it is preferred that the thin-film forming raw material be prevented from including particles to the extent possible in order to reduce or prevent particle contamination of a thin-film to be formed. Specifically, in particle measurement with a light scattering liquid particle detector in the thin-film forming raw material, it is preferred that the number of particles larger than 0.3 um be 100 or less in 1 ml of the thin-film forming raw material, and it is more preferred that the number of particles larger than 0.2 um be 100 or less in 1 ml of the thin-film forming raw material.

Next, the method of the present invention of producing a thin-film containing a zirconium atom (referred to as "zirconium-containing thin-film") by an ALD method through use of the above-mentioned thin-film forming raw material is more specifically described.

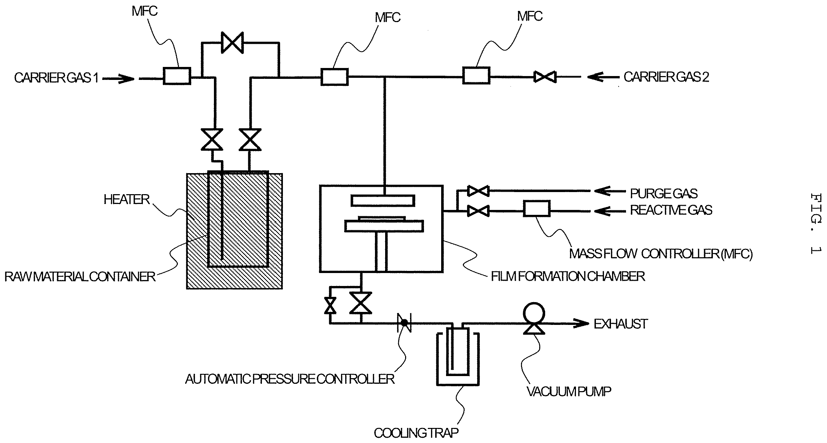

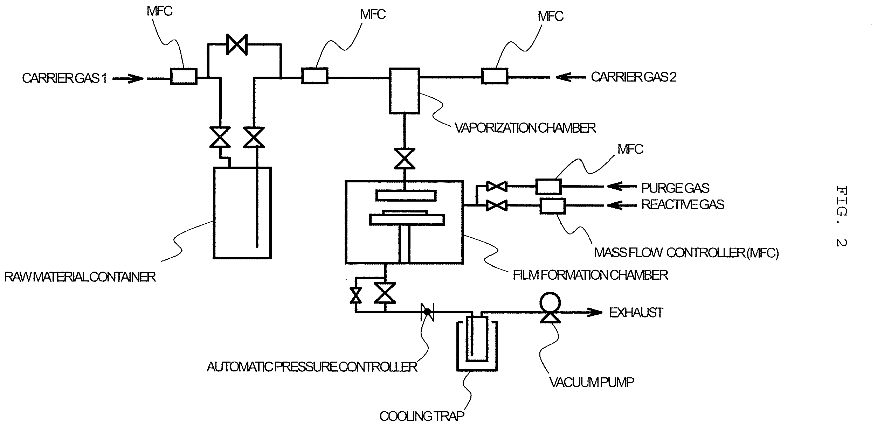

Specific examples of an ALD apparatus to be used in the method of producing a thin-film of the present invention include: such an apparatus as illustrated in FIG. 1 capable of heating and/or decompressing the thin-film forming raw material in a raw material container, to thereby vaporize the raw material to obtain a raw material gas, and supplying the raw material gas to a film formation chamber together with a carrier gas as required; and such an apparatus as illustrated in FIG. 2 capable of transporting the thin-film forming raw material under the state of a liquid or a solution to a vaporization chamber, heating and/or decompressing the raw material in the vaporization chamber, to thereby vaporize the raw material to obtain a raw material gas, and supplying the raw material gas to a film formation chamber. The apparatus is not limited to such a single-substrate type apparatus including a film formation chamber as illustrated in each of FIG. 1 and FIG. 2, and an apparatus capable of simultaneously processing a large number of substrates through use of a batch furnace may also be used.

The method of producing a thin-film of the present invention includes: a step 1 (precursor thin-film formation step) of, in a film formation chamber (hereinafter sometimes referred to as "deposition reaction portion") having a substrate set therein, causing a raw material gas obtained by vaporizing the thin-film forming raw material to adsorb to the surface of the substrate to form a precursor thin-film; a step 2 (evacuation step) of evacuating the raw material gas remaining unreacted; and a step 3 (zirconium-containing thin-film formation step) of introducing a reactive gas into the film formation chamber to cause the precursor thin-film to react with the reactive gas at a temperature of 240°C or more and 450°C or less, to thereby form a zirconium-containing thin-film on the surface of the substrate.

In addition, the method of producing a thin-film of the present invention preferably includes, after the step 3, a step 4 (evacuation step) of evacuating the gas in the film formation chamber.

In the method of producing a thin-film of the present invention, when deposition performed by a series of operations of the step 1 (precursor thin-film formation step), the step 2 (evacuation step), the step 3 (zirconium-containing thin-film formation step), and the step 4 (evacuation step) in the stated order is defined as one cycle, and the cycle is repeated a plurality of times, the thickness of the thin-film can be controlled. The steps of the method of producing a thin-film of the present invention are described below.

### (Step 1)

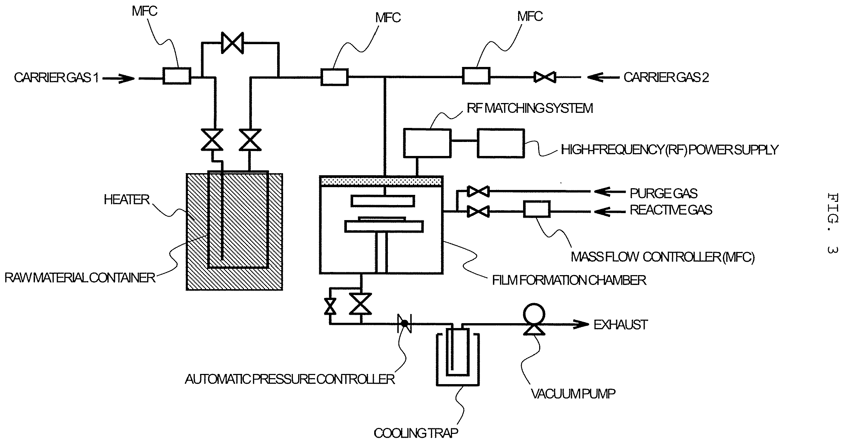

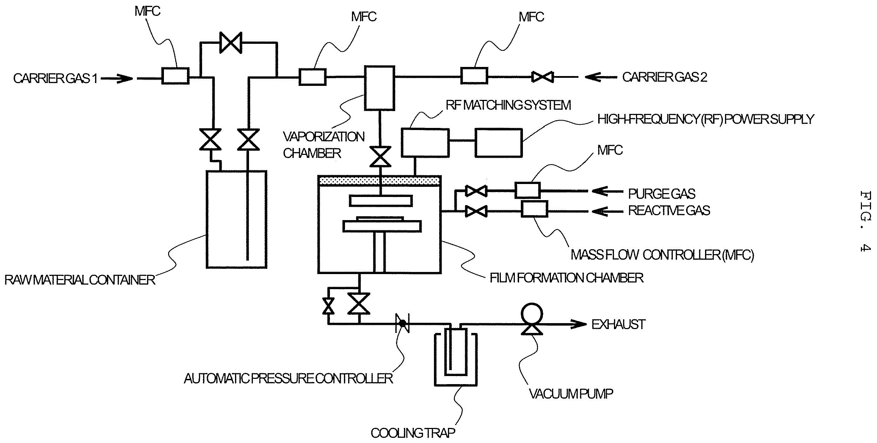

The step 1 is a step of introducing a raw material gas obtained by vaporizing the thin-film forming raw material into a film formation chamber having a substrate set therein to cause the raw material gas to adsorb to the surface of the substrate, to thereby form a precursor thin-film. As an introduction method for the raw material gas obtained by vaporizing the thin-film forming raw material into the film formation chamber having the substrate set therein, there are given: a gas transportation method involving heating and/or decompressing the thin-film forming raw material in a container in which the raw material is stored (hereinafter referred to as "raw material container"), to thereby vaporize the thin-film forming raw material to obtain a raw material gas, and introducing the raw material gas into the film formation chamber having the substrate set therein together with a carrier gas, such as argon, nitrogen, or helium, as required as illustrated in each of FIG. 1 and FIG. 3; and a liquid transportation method involving transporting the thin-film forming raw material under the state of a liquid or a solution to a vaporization chamber, heating and/or decompressing the raw material in the vaporization chamber, to thereby vaporize the thin-film forming raw material to obtain a raw material gas, and introducing the raw material gas into the film formation chamber having the substrate set therein as illustrated in each of FIG. 2 and FIG. 4. In the case of the gas transportation method, the zirconium compound represented by the general formula (1) itself may be used as the thin-film forming raw material. In the case of the liquid transportation method, the zirconium compound represented by the general formula (1) or a solution obtained by dissolving the zirconium compound in an organic solvent may be used as the thin-film forming raw material. Such thin-film forming raw material may further contain a nucleophilic reagent or the like.

In addition, as a method to be used in a raw material gas introduction step other than the gas transportation method and the liquid transportation method, there are given such a single source method and a cocktail source method as described above each serving as a multi-component ALD method including a plurality of precursors. Regardless of which introduction method is used, from the viewpoint of handleability, the thin-film forming raw material is preferably vaporized in the range of 0°C or more and 200°C or less. In addition, when the thin-film forming raw material is vaporized to provide the raw material gas in the raw material container or in the vaporization chamber, from the viewpoint that the thin-film forming raw material is easily vaporized, a pressure in the raw material container and a pressure in the vaporization chamber are each preferably 1 Pa or more and 10,000 Pa or less.

Herein, as a material for the substrate to be set in the film formation chamber, there are given, for example: silicon; ceramics, such as silicon nitride, titanium nitride, tantalum nitride, titanium oxide, ruthenium oxide, zirconium oxide, hafnium oxide, and lanthanum oxide; glass; and metals, such as metal cobalt and metal ruthenium. As a shape of the substrate, there are given, for example, a plate shape, a spherical shape, a fiber shape, and a scale-like shape. The surface of the substrate may be planar, or may have a three-dimensional structure such as a trench structure.

After the raw material gas is introduced into the film formation chamber, the precursor thin-film can be formed on the surface of the substrate by causing the raw material gas to adsorb to the surface of the substrate. At this time, the substrate may be heated, or an inside of the film formation chamber may be heated. The conditions at the time of forming the precursor thin-film are not particularly limited, and for example, an adsorption temperature (substrate temperature), a system pressure, or the like may be appropriately determined depending on the kind of the thin-film forming raw material. The step 1 is preferably performed under a state in which the substrate is heated to 240°C or more and 450°C or less. From the viewpoint that a uniform precursor thin-film is easily obtained, the step 1 is more preferably performed under a state in which the substrate is heated to 250°C or more and 400°C or less, and the step is still more preferably performed under a state in which the substrate is heated to 300°C or more and 400°C or less. The system pressure is not particularly limited, but is preferably 1 Pa or more and 10,000 Pa or less. From the viewpoint that a uniform precursor thin-film is easily obtained, the system pressure is more preferably 10 Pa or more and 1,000 Pa or less.

### (Step 2)

The step 2 is a step of evacuating, after the formation of the precursor thin-film, the raw material gas not having adsorbed to the surface of the substrate from the film formation chamber. In this step, it is ideal that the raw material gas not having adsorbed be completely evacuated from the film formation chamber, but it is not always required that the gas be completely evacuated. As an evacuation method, there are given, for example, a method involving purging the system of the film formation chamber with an inert gas, such as helium, nitrogen, or argon, a method involving performing evacuation by decompressing the system, and a combination of these methods. The degree of decompression in the case of performing decompression preferably falls within the range of 0.01 Pa or more and 300 Pa or less, and from the viewpoint that the evacuation of the raw material gas not having adsorbed is promoted, the degree of decompression more preferably falls within the range of 0.01 Pa or more and 100 Pa or less.

### (Step 3)

The step 3 is a step of, after the step 2, introducing a reactive gas into the film formation chamber to cause the precursor thin-film, that is, the zirconium compound represented by the general formula (1), which has been deposited on the surface of the substrate, to react with the reactive gas through the action of the reactive gas and the action of heat, to thereby form a zirconium-containing thin-film.

Examples of the reactive gas include: oxidizing gases, such as oxygen, ozone, nitrogen dioxide, nitrogen monoxide, water vapor, hydrogen peroxide, formic acid, acetic acid, and acetic anhydride; reducing gases such as hydrogen; and nitriding gases, such as organic amine compounds including a monoalkylamine, a dialkylamine, a trialkylamine, and an alkylenediamine, hydrazine, and ammonia. Those reactive gases may be used alone or as a mixture thereof. In the method of producing a thin-film of the present invention, the reactive gas is preferably an oxidizing gas, and from the viewpoint that reactivity between the precursor thin-film and the reactive gas becomes satisfactory, the reactive gas is more preferably a gas containing at least one selected from the group consisting of: oxygen; ozone; and water vapor. When the oxidizing gas is used as the reactive gas, a zirconium oxide thin-film is formed as the zirconium-containing thin-film.

A temperature (substrate temperature) at the time of causing the precursor thin-film to react with the reactive gas is 240°C or more and 450°C or less, and from the viewpoint that a high-quality thin-film more reduced in residual carbon is obtained, the temperature is preferably 250°C or more and 400°C or less, more preferably 300°C or more and 400°C or less. In addition, a pressure in the film formation chamber at the time of performing this step is preferably 1 Pa or more and 10,000 Pa or less, and from the viewpoint that reactivity between the precursor thin-film and the reactive gas becomes satisfactory, the pressure is more preferably 10 Pa or more and 1,000 Pa or less.

### (Step 4)

The step 4 is a step of, after the step 3, evacuating the reactive gas remaining unreacted and a by-product gas from the film formation chamber in order to produce a high-quality thin-film. In this step, it is ideal that the reactive gas and the by-product gas be completely evacuated from the film formation chamber, but it is not always required that the gases be completely evacuated. An evacuation method and the degree of decompression in the case of performing decompression are the same as those in the above-mentioned step 2.

When a series of operations of the step 1, the step 2, the step 3, and the step 4 described above is defined as one cycle, the film thickness of the zirconium-containing thin-film to be obtained can be controlled by the number of the cycles.

In addition, in the method of producing a thin-film of the present invention, energy, such as plasma, light, or a voltage, may be applied in the film formation chamber as illustrated in each of FIG. 3 and FIG. 4, or a catalyst may be used therein. The timing at which the energy is applied and the timing at which the catalyst is used are not particularly limited. The energy may be applied or the catalyst may be used, for example, at the time of the introduction of the raw material gas into the film formation chamber or at the time of the heating in forming the precursor thin-film in the step 1, at the time of the introduction of the reactive gas into the film formation chamber or at the time of causing the reactive gas and the precursor thin-film to react with each other in the step 3, at the time of the evacuation of the system in the step 2 or 4, or between the above-mentioned respective steps.

In addition, in the method of producing a thin-film of the present invention, after the thin-film formation, annealing treatment may be performed under an inert atmosphere, under an oxidizing atmosphere, or under a reducing atmosphere in order that more satisfactory electrical characteristics may be obtained. When step embedding is required, a reflow step may be provided. A temperature in this case is preferably 200°C or more and 1,000°C or less, and from the viewpoint that damage to the thin-film or the substrate caused by heat can be suppressed, the temperature is more preferably 250°C or more and 600°C or less.

The thin-film to be produced by the method of producing a thin-film of the present invention can be provided as a desired kind of thin-film by appropriately selecting the other precursor, the reactive gas, and the production conditions, to thereby coat the substrate made of, for example, a metal, an oxide ceramic, a nitride ceramic, or glass. The thin-film of the present invention is excellent in electrical characteristics and optical characteristics, and hence can be widely used in the production of, for example, an electrode material for a memory element typified by a DRAM element, a resistance film, a diamagnetic film used in the recording layer of a hard disk, and a catalyst material for a polymer electrolyte fuel cell.

### Examples

The present invention is described in more detail below by way of Examples. However, the present invention is by no means limited by Examples and the like below.

The following test compounds were subjected to the following evaluations.
No. 1: zirconium tetrakis[1-(dimethylamino)-2-propanolate]
No. 4: zirconium tetrakis[1-(dimethylamino)-2-methyl-2-propanolate]
Comparative Compound 1: zirconium tetrakis[1-(dimethylamino)ethanolate]
Comparative Compound 2: tetrakis(ethylmethylamino)zirconium

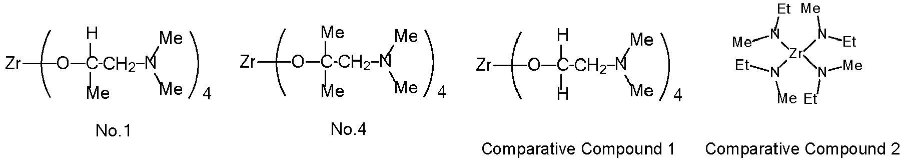

### (1) Melting Point Evaluation

The state of each of the compounds at normal pressure and 25°C was visually observed. The results are shown in Table 1.

### (2) Thermal Decomposition Starting Temperature

In a DSC chart measured with a differential scanning calorimeter (DSC) at an argon flow rate of 20 mL/min and a temperature increase rate of 10°C/min in a scanning temperature range of from 30°C to 500°C, an exothermic or endothermic starting point was evaluated as a thermal decomposition starting temperature (°C). The results are shown in Table 1.

**Table 1**

| Test compound | No. 1 | No. 4 | Comparative Compound 1 | Comparative Compound 2 |
|---|---|---|---|---|
| Melting point evaluation | Colorless liquid | Colorless liquid | Colorless liquid | Pale yellow liquid |
| Thermal decomposition starting temperature | 340°C | 381°C | 335°C | 249°C |

Next, a thin-film was produced through use of each of the test compounds as a thin-film forming raw material.

### [Example 1]

A thin-film was produced on a silicon wafer serving as a substrate through use of the above-mentioned Zirconium Compound No. 1 as a thin-film forming raw material with the ALD apparatus of FIG. 1 under the following conditions and through the following steps. When the composition of the thin-film was analyzed by X-ray photoelectron spectroscopy, it was recognized that the thin-film was a zirconium oxide thin-film, and a residual carbon content in the thin-film was less than 0.01 atm%, which was a detection limit. In addition, when the film thickness of the thin-film was measured by an X-ray reflectivity method, the thin-film formed on the substrate was a flat and smooth film having a film thickness of 4.0 nm, and a film thickness of about 0.040 nm was obtained per cycle.

### (Conditions)

Production method: ALD method
Reaction temperature (substrate temperature): 300°C
Reactive gas: mixed gas of ozone and oxygen

### (Steps)

A series of steps including the following step 1 to step 4 was defined as one cycle, and this cycle was repeated 100 times.

Step 1: Vapor (raw material gas) of the thin-film forming raw material obtained by vaporization under the conditions of a raw material container temperature of 150°C and a raw material container internal pressure of 26.67 Pa is introduced into a film formation chamber, and the raw material gas is caused to adsorb to the surface of the substrate at a system pressure of 26.67 Pa for 30 seconds, to thereby form a precursor thin-film.

Step 2: The raw material gas not having adsorbed is evacuated from the system through argon purging for 30 seconds.

Step 3: The reactive gas is introduced into the film formation chamber, and the precursor thin-film is caused to react with the reactive gas at a system pressure of 100 Pa for 10 seconds.

Step 4: The reactive gas remaining unreacted and a by-product gas are evacuated from the system through argon purging for 15 seconds.

### [Example 2]

A thin-film was produced on a silicon wafer serving as a substrate in the same manner as in Example 1 except that Zirconium Compound No. 1 was changed to Zirconium Compound No. 4. When the composition of the thin-film was analyzed by X-ray photoelectron spectroscopy, it was recognized that the thin-film was a zirconium oxide thin-film, and a residual carbon content in the thin-film was less than 0.01 atm%, which was a detection limit. In addition, when the film thickness of the thin-film was measured by an X-ray reflectivity method, the thin-film formed on the substrate was a flat and smooth film having a film thickness of 3.9 nm, and a film thickness of about 0.039 nm was obtained per cycle.

### [Example 3]

A thin-film was produced on a silicon wafer serving as a substrate under the same conditions as those in Example 1 except that the substrate temperature in each of the step 1 and the step 3 was changed from 300°C to 400°C. When the composition of the thin-film was analyzed by X-ray photoelectron spectroscopy, it was recognized that the thin-film was a zirconium oxide thin-film, and a residual carbon content in the thin-film was less than 0.01 atm%, which was a detection limit. In addition, when the film thickness of the thin-film was measured by an X-ray reflectivity method, the thin-film was a flat and smooth film having a film thickness of 5.30 nm, and a film thickness of about 0.053 nm was obtained per cycle.

### [Example 4]

A thin-film was produced on a silicon wafer serving as a substrate under the same conditions as those in Example 1 except that the substrate temperature in each of the step 1 and the step 3 was changed from 300°C to 450°C. When the composition of the thin-film was analyzed by X-ray photoelectron spectroscopy, the thin-film was a zirconium oxide thin-film, and a residual carbon content in the thin-film was 0.76 atm%. In addition, when the film thickness of the thin-film was measured by an X-ray reflectivity method, the thin-film was a flat and smooth film having a film thickness of 9.72 nm, and a film thickness of about 0.097 nm was obtained per cycle.

### [Comparative Example 1]

A thin-film was produced on a silicon wafer serving as a substrate under the same conditions as those in Example 1 except that Zirconium Compound No. 1 was changed to Comparative Compound 1. When the composition of the thin-film was analyzed by X-ray photoelectron spectroscopy, the thin-film was a zirconium oxide thin-film, and a residual carbon content in the thin-film was 0.81 atm%. In addition, when the film thickness of the thin-film was measured by an X-ray reflectivity method, the thin-film was a flat and smooth film having a film thickness of 4.23 nm, and a film thickness of about 0.042 nm was obtained per cycle.

### [Comparative Example 2]

A thin-film was produced on a silicon wafer serving as a substrate under the same conditions as those in Example 1 except that Zirconium Compound No. 1 was changed to Comparative Compound 2. When the composition of the thin-film was analyzed by X-ray photoelectron spectroscopy, the thin-film was a zirconium oxide thin-film, and a residual carbon content in the thin-film was 5.81 atm%. In addition, when the film thickness of the thin-film was measured by an X-ray reflectivity method, the thin-film was a flat and smooth film having a film thickness of 39.1 nm, and a film thickness of about 0.39 nm was obtained per cycle. At 300°C, ALD saturation did not occur, and an increase in film forming speed (deterioration in film controllability) and deterioration in composition of the film caused by thermal decomposition deposition were observed.

### [Comparative Example 3]

A thin-film was produced on a silicon wafer serving as a substrate under the same conditions as those in Example 1 except that the substrate temperature in each of the step 1 and the step 3 was changed from 300°C to 230°C. When the composition of the thin-film was analyzed by X-ray photoelectron spectroscopy, the thin-film was a zirconium oxide thin-film, and a residual carbon content in the thin-film was 1.74 atm%. In addition, when the film thickness of the thin-film was measured by an X-ray reflectivity method, the thin-film was a flat and smooth film having a film thickness of 3.64 nm, and a film thickness of about 0.036 nm was obtained per cycle.

### [Comparative Example 4]

A thin-film was produced on a silicon wafer serving as a substrate under the same conditions as those in Example 1 except that the substrate temperature in each of the step 1 and the step 3 was changed from 300°C to 470°C. When the composition of the thin-film was analyzed by X-ray photoelectron spectroscopy, the thin-film was a zirconium oxide thin-film, and a residual carbon content in the thin-film was 0.88 atm%. In addition, when the film thickness of the thin-film was measured by an X-ray reflectivity method, the thin-film was a flat and smooth film having a film thickness of 10.63 nm, and a film thickness of about 0.106 nm was obtained per cycle.

As described above, in the present invention, when a thin-film is produced through use of the thin-film forming raw material containing the specific zirconium compound under the specific conditions, a high-quality zirconium-containing thin-film reduced in residual carbon can be produced.

## Claims

1. A method of producing a thin-film containing a zirconium atom on a surface of a substrate by an atomic layer deposition method, comprising:
a step 1 of causing a raw material gas obtained by vaporizing a thin-film forming raw material containing a zirconium compound represented by the following general formula (1) to adsorb to the surface of the substrate to form a precursor thin-film;
a step 2 of evacuating the raw material gas remaining unreacted; and
a step 3 of causing the precursor thin-film to react with a reactive gas at a temperature of 240°C or more and 450°C or less to form the thin-film containing a zirconium atom on the surface of the substrate: 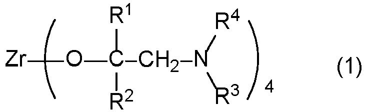 wherein R¹ and R² each independently represent a hydrogen atom or an alkyl group having 1 to 3 carbon atoms, and R³ and R⁴ each independently represent an alkyl group having 1 to 3 carbon atoms, provided that a zirconium compound in which both of R¹ and R² represent hydrogen atoms is excluded.

2. The method of producing a thin-film according to claim 1, wherein the step 1 is performed under a state in which the substrate is heated to 240°C or more and 450°C or less.

3. The method of producing a thin-film according to claim 1 or 2,
wherein the reactive gas is an oxidizing gas, and
wherein the thin-film containing a zirconium atom is zirconium oxide.

4. The method of producing a thin-film according to any one of claims 1 to 3, wherein the reactive gas is a gas containing at least one selected from the group consisting of: oxygen; ozone; and water vapor.
